# EUROPÄISCHE PATENTANMELDUNG

(11) **EP 1 858 079 A2**
(43) Veröffentlichungstag der Anmeldung: **21.11.2007**
(21) Anmeldenummer: 07102702.3
(22) Anmeldetag: 20.02.2007
(51) Int. Cl.: H01L 23/467

(54) **Anordnung zur Kühlung von SMD-Leistungsbauelementen auf einer Leiterplatte**

(30) Priorität: 16.05.2006 AT 8462006
(71) Anmelder: Siemens Aktiengesellschaft Österreich, 1210 Wien (AT)
(72) Erfinder: Hellinger, Leopold, 3710, Ziersdorf (AT); Neumann, Gerhard, 3231, St. Margarethen (AT)

(57) **Zusammenfassung**

Anordnung zur Kühlung von auf einem plattenförmigen Trägersubstrat (2) angeordneten elektrischen Bauelementen (1), insbesondere von SMD-Leistungsbauelementen auf einer Leiterplatte, wobei zumindest ein, einem Bauelement (1) zugeordneter Kühlkörper (3) vorhanden ist, der auf der gleichen Seite mit den Bauelementen angeordnet ist und der mittels einer Wärmeleitschicht (4), die auf dem Trägersubstrat (2) ausgebildet ist, mit dem zugeordneten Bauelement wärmeleitend verbunden ist, wobei
der Kühlkörper (3) als Blechbiegeteil ausgebildet ist und mittels einer Lötverbindung (11) mit der Wärmeleitschicht (4) verbunden ist, und
dass das Blechbiegeteil zumindest ein Kühlkörperelement (8) aufweist, das sich in einer Längsrichtung erstreckt und diese Längsrichtung bezüglich der Ebene (5) des plattenförmigen Trägers (2) schräg ausgerichtet ist.

## Beschreibung

### Technisches Gebiet

Die Erfindung betrifft eine Anordnung zur Kühlung von auf einem plattenförmigen Trägersubstrat angeordneten elektrischen Bauelementen, insbesondere von SMD-Leistungsbauelementen auf einer Leiterplatte, wobei zumindest ein Kühlkörper vorhanden ist, der auf der gleichen Seite mit den Bauelementen angeordnet ist und der mit einem zugeordneten Bauelement mittels einer Wärmeleitschicht, die auf dem Trägersubstrat ausgebildet ist, wärmeleitend verbunden ist.

### Stand der Technik

Zur Kühlung von Leistungsbauelementen, die in Oberflächenmontage (SMT Surface Mount Technology) montiert sind, sind verschiedene Entwärmungskonzepte bekannt. Die Wärmeabfuhr kann durch Kühlkörper erfolgen, die entweder auf der Bestückungsseite oder auf der Rückseite der Leiterplatte angeordnet sind.

Aus der DE 43 32 115 B4 ist eine Anordnung zur Kühlung einer Leiterplatte bekannt, bei der ein Kühlkörper verwendet wird, der auf der Bestückungsseite angeordnet ist. Eine elektrisch isolierende aber wärmeleitende Klebefolie verbindet den Kühlkörper mit den Leiterbahnen, die zum SMD-Bauelement führen. Die wärmeleitende Klebefolie besitzt aber selbst einen thermischen Widerstand. Das Aufbringen der Klebefolie erfordert bei der Herstellung einen zusätzlichen Verfahrensschritt. Die Kühlrippen stehen senkrecht zur Ebene der Bestückungsseite der Leiterplatte. Bei natürlicher Konvektion ist die Kühlung deshalb von der Raumlage der Leiterplatte abhängig.

Ein elektrisches Gerät mit einer Leiterplatte, bei der SMD-Bauelemente durch einen Kühlkörper auf der Unterseite der Leiterplatte gekühlt werden, ist aus der DE 199 10 500 A1 bekannt. Mittels thermischer Durchkontaktierungen (thermal vias) wird die auf der Bestückungsseite anfallende Verlustwärmemenge auf die Rückseite der Leiterplatte geleitet. Die thermische Durchkontaktierung stellt bei der Herstellung der Leiterplatte ebenfalls einen erhöhten Aufwand dar.

Diese bekannten Entwärmungskonzepte sind also in der Herstellung aufwändig und haben darüber hinaus den Nachteil, dass die Entwärmung bei natürlicher Konvektion von der Einbaulage abhängig ist. Im ungünstigsten Fall kann ein Wärmestau auftreten, der die Funktionsfähigkeit der SMD Schaltung beeinträchtigen kann.

### Darstellung der Erfindung

Der vorliegenden Erfindung liegt die Aufgabe zu Grunde, eine Anordnung zur Kühlung von SMD-Leistungsbauelementen anzugeben, bei der das Wärmeableitungsvermögen in einem möglichst geringeren Ausmaße von der Einbaulage abhängig und die in der Herstellung möglichst einfach und kostengünstig ist.

Diese Aufgabe wird durch eine Anordnung mit den Merkmalen des Anspruchs 1 gelöst. Vorteilhafte Ausgestaltungen sind Gegenstand von abhängigen Ansprüchen.

Die Erfindung geht von der Erkenntnis aus, dass durch einen Kühlkörper mit schräg zur Leiterplatte ausgerichteten Wärmeableitelementen eine von der Einbaulage weitgehend unabhängige Wärmeabfuhr erzielt werden kann. M. a. W., die für die Wärmeabgabe an die Umgebungsluft maßgeblichen Teile des Kühlkörpers sind nicht waagerecht oder senkrecht bezüglich der Ebene des Schaltungsträgers ausgerichtet, sondern seitlich geneigt. Dadurch verringert sich die Lageabhängigkeit der Kühlwirkung. In Folge davon verbesserte sich die Zuverlässigkeit der in SMD-Technik aufgebauten Schaltung. Die schräg zur Leiterplattenebene ausgebildeten Wärmeableitelemente können kostengünstig als Blechbiegeteil hergestellt werden. Die für die Wärmeabgabe an die Umgebungsluft maßgeblichen Teile des Kühlkörpers können fingerförmig oder flächenförmig ausgebildet sein. Erfindungsgemäß ist das Blechbiegeteil mittels einer Lötverbindung mit einer Wärmeleit- oder Wärmeverteilerschicht, auf der das zu kühlende Bauelement montiert ist, verbunden.
Das Blechbiegteil kann wie ein SMD-Bauteil durch "pick and place" Bestückungsautomaten automatisch gehandhabt werden. Dadurch lässt sich die gesamte Kühlanordnung kostengünstig herstellen.

Eine hinsichtlich der Fertigung günstige Ausgestaltung des Blechbiegeteils kann dadurch gekennzeichnet sein, das es einen U-förmig gebogenen Abschnitt aufweist, dessen Schenkel sind mit der Wärmeleitschicht verlötet sind. An jeder Stirnseite des U-förmig gebogenen Abschnittes sind die Kühlkörperelemente durch gebogene Blechabschnitte gebildet.

Eine sehr gute Entwärmung lässt sich durch eine Ausführung erreichen, bei der die Kühlkörperelemente flächenförmig ausgebildet sind und Wärmeableitungsflächen aufweisen, welche jeweils mit der Ebene des plattenförmigen Trägersubstrats einen spitzen Winkel einschließen.

Bei dieser Ausführung kann es vorteilhaft sein, dass die flächenförmigen Kühlkörperelemente T-förmig ausgebildet sind und abgewinkelte Endstücke aufweisen.

Eine andere vorteilhafte Ausgestaltung kann dadurch gekennzeichnet sein, dass die Kühlkörperelemente als Kühlfinger ausgebildet sind, die fächerförmig in den oberhalb der Ebene der Bestückungsseite liegenden Halbraum des Trägersubstrats ragen.

Für den automatischen Lötprozess kann es günstig sein, wenn das Biegeblechteil mit einer lötbaren Oberfläche beschichtet, z.B. Zinn-, Nickel- oder Weißbronzeschicht, oder aus einem lötbaren Material hergestellt ist.

Günstig für die Fertigung ist ferner eine Anordnung, bei der der Kühlkörper mit seinen beiden U-förmigen Schenkel benachbart zu jenen Seiten des quaderförmigen SMD-Leistungsbauelements liegt, an welchen keine Anschlusskontakte ausgebildet sind. Auf diese Weise kann die Lötbefestigung des Blechbiegteils zusammen mit dem Löten der elektrischen Anschlusskontakte erfolgen.

Für die automatische "pick and place" Handhabung kann es günstig sein, wenn das U-förmige Blechbiegeteil eine Flachseite aufweist, so dass ein Saugarm einer automatischen SMD-Bestückungsmaschine das Blechbiegteil sicher greifen und transportieren kann.

Eine besonders kostengünstige Ausbildung der Erfindung kann dadurch gekennzeichnet, dass das Blechbiegeteil aus einem Kupferblech besteht und durch Stanz-Biege-Technik hergestellt ist.

### Kurzbeschreibung der Zeichnung

Zur weiteren Erläuterung der Erfindung wird im nachfolgenden Teil der Beschreibung auf die Zeichnungen Bezug genommen aus denen weitere vorteilhafte Ausgestaltungen, Einzelheiten und Weiterbildungen der Erfindung zu entnehmen sind. Es zeigen:
- Figur 1: eine perspektivische Ansicht einer erfindungsgemäßen Anordnung zur Entwärmung von SMD-Leistungsbauelementen auf einem plattenförmigen Trägersubstrat;
- Figur 2: einen Kühlkörper wie er in der erfindungsgemäßen Anordnung gemäß Figur 1 eingesetzt wird in einer dreidimensionalen Darstellung;
- Figur 3: einen Schnitt durch ein SMD-Bauelement mit einem darüber angeordneten Kühlkörper gemäß der Linie A-A in einem Ausschnitt der Figur 1.

### Ausführung der Erfindung

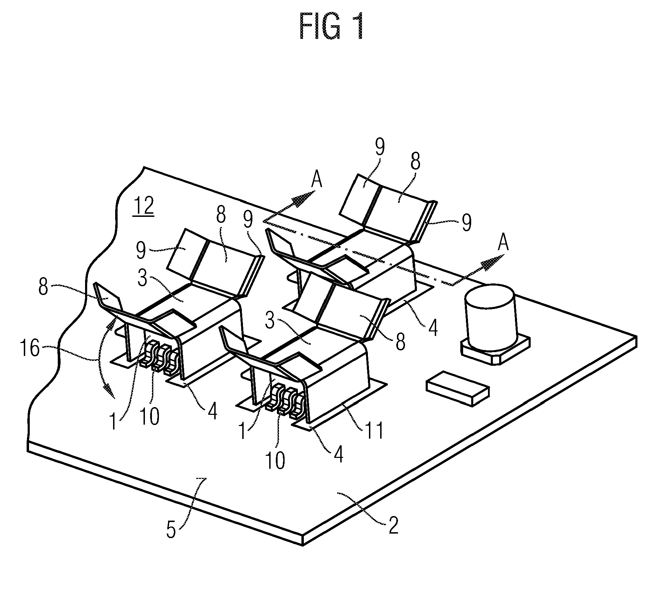

Die Figur 1 zeigt ein Ausführungsbeispiel der erfindungsgemäßen Kühlanordnung, wie sie für eine Dimmer-Steuerung in der Elektroinstallationstechnik (Elektroinstallations-Bus EIB) eingesetzt wird.

Auf einer Leiterplatte 2 sind auf einer Bestückungsseite 5 Leistungsbauelemente 1 in Oberflächenmontage (SMT-Technik) montiert. Diese SMD-Bauelemente weisen Anschlusskontakte 10 auf, die mit nicht näher dargestellten Leiterbahnen elektrisch verbunden sind. Jedes SMD-Leistungsbauelement 1 in Figur 1 liegt wärmeleitend auf einer Wärmeleit- oder Verteilerschicht 4, die auf der Bestückungsfläche 5 ausgebildet ist, auf. Die Wärmeleitschicht 4 weist dabei die Form eines Doppel-T auf. Ein U-förmig ausgebildeter Kühlkörper 3, der auf der gleichen Seite wie die Bauelemente 1 des Trägersubstrats 2 angeordnet ist, umgibt nach Art eines Tunnels jedes dieser SMD-Leistungsbauelemente 1. Der Kühlkörper 3 ist einstückig aus einem Kupferblech gebildet. Die Herstellung dieses Blechbiegeteils erfolgt vorzugsweise in Stanz-Biege-Technik.

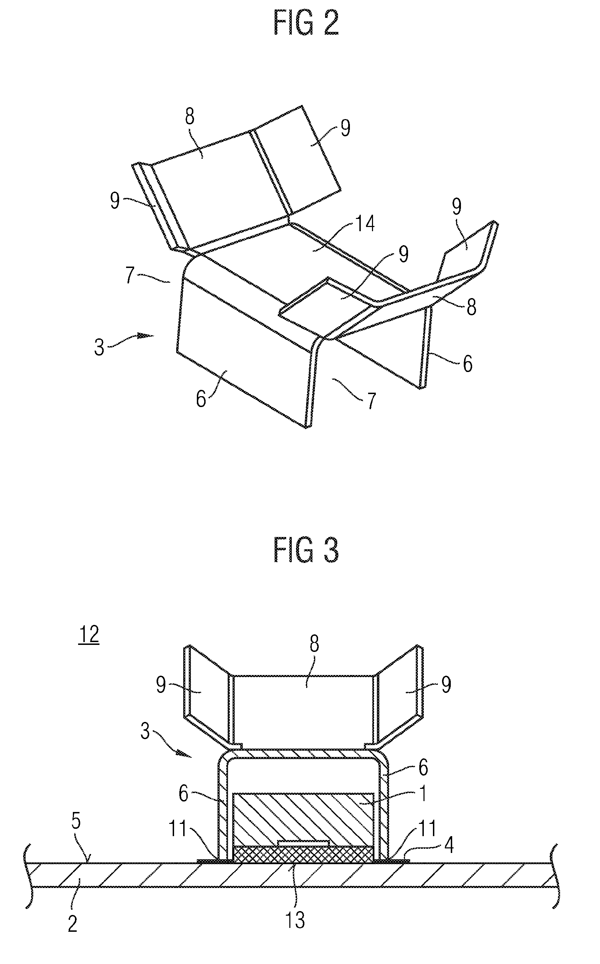

In Figur 2 ist dieses Blechbiegteil 3 in einer räumlichen Darstellung gesondert dargestellt. Es besteht im Wesentlichen aus einem u-förmigen Abschnitt 15, der sich aus den beiden Schenkeln 6 und einer Flachseite 14 zusammensetzt. An diesem U-förmigen Abschnitt 15 ist jeweils an einer Stirnseite 7 ein Kühlkörperelement 8 in Form eines T-förmiger Blechlappens ausgebildet. Der Blechlappen 8 ist bezüglich der Ebene 5 hoch gebogen, und weist seinerseits wieder bezüglich des Mittelteils eines jeden Lappens 8 gebogene Endstücke 9 auf.

Wie am besten anhand der Figur 3 zu erkennen ist, sind in einer Montagenstellung die beiden Schenkel 6 des U-förmigen Abschnittes 15 des Blechbiegeteils 3 jeweils durch eine Lötverbindung 11 mit der Wärmeleitschicht 4 verlötet. Die bei Betrieb in einem SMD-Leistungsbauelement 1 anfallende Verlustleistung gelangt so über die Wärmekontaktfläche 13 auf die Wärmeleitschicht 4. Von dort wird der Wärmestrom verteilt und in die Doppel-T-Abschnitte geleitet. Über die Lötverbindung 11 gelangt der Wärmestrom in die Schenkel 6 des Kühlkörpers 3 und von dort weiter in die für den konvektiven Wärmeaustausch ausgebildeten Kühlkörperelemente 8. Die Kühlkörperelemente 8 ähneln ihre Gestalt nach "Flügel" die von der Stirnseite 7 des U-förmigen Abschnitts 15 in den Halbraum 12 nach oben zeigen. Diese "Flügel" sind durch die beiden Lappen 8 des Blechbiegeteils 3 gebildet. Jeder dieser Lappen 8 schließt mit der Ebene 5 des Trägers 2 einen spitzten Winkel 16 ein, d.h. jeder Lappen 8 zeigt samt den beiden Endstücken 9 nach oben in den Halbraum 12. Die beiden Lappen 8 eines Kühlkörpers können unterschiedlich große Winkel mit der Ebene 5 einschließen.

Da der Kühlkörper 3 auf der Seite der Bauteile 1 des Trägersubstrats 2 angeordnet ist, erfolgt die Wärmeabfuhr von der Seite auf der sie anfällt; aufwendig herzustellende thermische Durchkontaktierungen sind nicht erforderlich.

Durch die dargestellte Ausbildung des Kühlkörpers 3 wird zum einen eine gute Wärmeableitwirkung erreicht. Diese Wärmeableitwirkung ist weniger stark von der Raumlage des Trägersubstrats 1 abhängig, als dies bei einem Kühlkörper der als Strang-Press-Profil ausgebildet ist, der Fall ist. Dadurch kann wirkungsvoll einem Wärmestau entgegengewirkt werden. Der vom Bauelement 1 zum Kühlkörper 3 geführte Wärmestrom muss nicht den Wärmewiderstand einer Klebstoffschicht überwinden, was eine geringere Temperatur im Bauelement 2 bedeutet. Die Zuverlässigkeit einer elektronischen Schaltung in SMD-Bauweise kann dadurch verbessert werden. Zum anderen kann der aus einem Blechbiegeteil hergestellten Kühlkörper 3 kostengünstig in hoher Stückzahl, beispielsweise mittels eines Folge-Verbund-Werkzeuges erzeugt werden. Für eine Fertigung in Großserien ist dies von entscheidendem Vorteil. Im Vergleich zu einem Kühlkörper, der als Strang-Pressteil hergestellt ist, ergibt sich ein Gewichtsvorteil und eine Materialersparnis.

Ein weiterer Vorteil ergibt sich bei der Herstellung der SMD-Schaltung. Die Handhabung und Platzierung des Kühlkörpers 3 erfolgt ähnlich einem SMD Bauteil: Die Kühlkörper 3 werden zum Bestückungsautomaten in einer herkömmlichen Verpackung durch einen Gurt o. Ä. zugeführt. Die Saugpipette des Bestückungsautomaten ergreift einen Kühlkörper 3 auf dem Gurt an der Flachseite 14 und positioniert ihn auf dem Trägersubstrat 2 auf dem mit Weichlot versehenen Doppel-T-Randbereichen der Wärmeleitschicht 4. Die Lötverbindung 11 mit der aufgedruckten Lotpaste kann dann in üblicherweise durch das sog. Wiederaufschmelzlöten, auch Reflow-Lötverfahren genannt, erfolgen. Das Reflow-Lötverfahren ist ein Weichlötverfahren, bei dem das Weichlot vor der Bestückung auf die Platine aufgetragen wird. Im Anschluss daran erfolgt die Bestückung. In einem dritten Schritt erfolgt dann die Wärmezufuhr. Diese kann auf unterschiedliche Weise erfolgen, beispielsweise mittels Infrarotstrahlung, Laserstrahlung, erhitzte Luft oder mittels einer Heizplatte.

Die mechanische Befestigung des Kühlkörpers 3 auf dem Trägersubstrat 2 erfolgt ausschließlich durch die Lötverbindung 11. Wie aus Figur 1 zu erkennen ist, liegen die Schenkel 6 - und damit die Lötverbindung 11 - benachbart zu jenen Seiten des quaderförmigen Bauelements 1, an denen keine Anschlusskontakte 10 ausgebildet bzw. Leiterbahnen herangeführt sind. Die Lötverbindung 11 kann daher im gleichen Arbeitsgang wie das Herstellen der elektrischen Lötverbindungen 11 zwischen Leiterbahnen und Anschlusskontakten 10 hergestellt werden. Es ist weder das Aufbringen eines Klebstoffs noch sind sonstige Befestigungsmittel für den Kühlkörper 3 erforderlich.

Die Herstellung der erfindungsgemäßen Kühlanordnung erfordert damit kaum Änderungen an bestehenden SMD-Bestückungsautomaten.

Selbstverständlich ist es auch möglich, zuerst die elektrischen Bauelemente mittels einer hochschmelzenden Lotpaste und dann, in einem zweiten Schritt, den Kühlkörper 3 mittels einer niedrigschmelzenden Lotpaste zu löten.

Das im vorliegenden Ausführungsbeispiel flächenförmig ausgebildete Kühlkörperelement 8 kann auch zwecks verbesserter Wärmeabgabe an die Umgebungsluft durch Langlöcher durchsetzt bzw. durch fingerförmig ausgebildete, fächerartig auseinander gebogene Rippen ausgebildet sein.

Das Blechbiegeteil ist auf einem Kupferblech hergestellt. Nach der spanlosen Formgebung wird das Blechbiegeteil verzinnt, wodurch die Ausbildung einer Oxidschicht, die für das Herstellen der Lötverbindung 11 ungünstig wäre, vermieden wird. Selbstverständlich sind auch andere gut lötbare Werkstoffe bzw. Beschichtungen möglich.

Die Wärmeleitschicht 4 ist im vorliegenden Ausführungsbeispiel eine auf der Bestückungsseite 5 ausgebildete kupferkaschierte Schicht. Die Wärmeleitschicht 4 kann aber auch anders ausgebildet sein, zum Beispiel durch eine auflaminierte Metallschicht, oder durch ein Einpressteil, das in einer Öffnung oder Ausnehmung des Trägersubstrats 2 mittels Pressesitz befestigt ist.

### Zusammenstellung der verwendeten Bezugszeichen

- 1: SMD-Leistungsbauelement
- 2: Leiterplatte
- 3: Kühlkörper
- 4: Wärmeleitschicht
- 5: Eben der Bestückungsseite
- 6: Schenkel
- 7: Stirnseite
- 8: Kühlkörperelement
- 9: Endstück
- 10: Anschlusskontakt
- 11: Lötverbindung
- 12: Halbraum
- 13: Wärmekontaktfläche
- 14: Flachseite
- 15: U-förmiger Abschnitt
- 16: Winkel

## Patentansprüche

1. Anordnung zur Kühlung von auf einem plattenförmigen Trägersubstrat (2) angeordneten elektrischen Bauelementen (1), insbesondere von SMD-Leistungsbauelementen auf einer Leiterplatte, wobei zumindest ein, einem Bauelement (1) zugeordneter Kühlkörper (3) vorhanden ist, der auf der gleichen Seite mit den Bauelementen angeordnet ist und der mittels einer Wärmeleitschicht (4), die auf dem Trägersubstrat (2) ausgebildet ist, mit dem zugeordneten Bauelement (1) wärmeleitend verbunden ist, **dadurch gekennzeichnet,**
- **dass** der Kühlkörper (3) als Blechbiegeteil ausgebildet ist und mittels einer Lötverbindung (11) mit der Wärmeleitschicht (4) verbunden ist,
- **dass** das Blechbiegeteil zumindest ein Kühlkörperelement (8) aufweist, das sich in einer Längsrichtung erstreckt und diese Längsrichtung bezüglich der Ebene (5) des plattenförmigen Trägers (2) schräg ausgerichtet ist.

2. Anordnung nach Anspruch 1, **dadurch gekennzeichnet, dass** das Blechbiegeteil (3) einen U-förmig gebogenen Abschnitt (15) aufweist, dessen Schenkel (6) endseitig mittels der Lötverbindung (11) mit der Wärmeleitschicht (4) verbunden sind und an jeder Stirnseite (7) des U-förmig gebogenen Abschnittes (15) die Kühlkörperelemente (8) durch hoch gebogene Blechabschnitte gebildet sind.

3. Anordnung nach Anspruch 2, **dadurch gekennzeichnet, dass** die Kühlkörperelemente (8) flächenförmig ausgebildet sind und Wärmeableitungsflächen aufweisen, welche jeweils mit der Ebene (5) des plattenförmigen Trägersubstrats (2) einen spitzen Winkel (16) einschließen (Fig.1).

4. Anordnung nach Anspruch 4, **dadurch gekennzeichnet, dass** die flächenförmigen Kühlkörperelemente (8) T-förmig ausgebildet sind und abgewinkelte Endstücke (9) aufweisen.

5. Anordnung nach Anspruch 2, **dadurch gekennzeichnet, dass** die Kühlkörperelemente (8) als Kühlfinger ausgebildet sind die fächerförmig in den oberhalb der Ebene (5) Bestückungsseite liegenden Halbraum (12) des Trägersubstrats (2) ragen.

6. Anordnung nach einem der Ansprüche 3 bis 5, **dadurch gekennzeichnet, dass** das Blechteil (3) mit einer lötbaren Oberfläche beschichtet oder aus einem lötbaren Material hergestellt ist.

7. Anordnung nach einem der Ansprüche 2 bis 6, **dadurch gekennzeichnet, dass** das dem Kühlkörper (3) zugeordnete SMD-Leistungsbauelement quaderförmig ausgebildet ist und die beiden U-förmigen Schenkel (6) an jenen, paarweise gegenüberliegenden Seiten des SMD-Leistungsbauelements (1) angeordnet sind, welche keine Anschlusskontakte aufweisen.

8. Anordnung nach einem der Ansprüche 2 bis 7, **dadurch gekennzeichnet, dass** das U-förmige Blechteil ein Flachseite (14) aufweist.

9. Anordnung nach einem der vorstehenden Ansprüche **dadurch gekennzeichnet, dass** das Blechbiegeteil (3) aus einem Kupferblech mittels Stanz-Biege-Technik hergestellt ist.

10. Anordnung nach einem der vorstehenden Ansprüche, **dadurch gekennzeichnet, dass** das Blechbiegeteil (3) zumindest teilweise mit Zinn beschichtet ist.
